# EUROPEAN PATENT APPLICATION

(11) **EP 1 391 919 A1**
(43) Date of publication of application: **25.02.2004**
(21) Application number: 02718530.5
(22) Date of filing: 11.04.2002
(51) Int. Cl.: H01L 21/02

(54) **CERAMIC HEATER FOR SEMICONDUCTOR MANUFACTRING/INSPECTING APPARATUS**

(30) Priority: 11.04.2001 JP 2001113247
(71) Applicant: IBIDEN CO., LTD., Ogaki-shi Gifu-ken 503-0917 (JP)
(72) Inventor: ITO, Yasutaka, c/o IBIDEN CO., LTD, Ibi-gun, Gifu 501-0695 (JP)
(74) Representative: Forstmeyer, Dietmar, Dr. rer. nat., Dipl.-Chem.
(86) International application number: PCT/JP2002/003608
(87) International publication number: WO 2002/084717

(57) **Abstract**

An object of the present invention is to provide a ceramic heater for a semiconductor producing/inspecting device which makes it possible to realize an even temperature distribution in a semiconductor wafer without corroding external terminals, wires and the like of the ceramic heater in the process of producing a semiconductor. The present invention is directed to a ceramic heater for a semiconductor producing/inspecting device comprising: a ceramic substrate; and a resistance heating element formed inside the ceramic substrate, wherein a power feeding terminal is exposed and formed at the outside of a wafer-heating region in the ceramic substrate.

## Description

### Technical Field

The present invention relates to a ceramic heater for a semiconductor producing/inspecting device used in a ceramic heater, an electrostatic chuck, a chuck top plate for a wafer prober, and the like mainly in the semiconductor industry.

### Background Art

Conventionally, a heater using a metal base such as stainless steel or aluminum alloy has been used in semiconductor producing/inspecting devices or other devices, examples of which include an etching device and a chemical gas phase growth device and the like.

However, such a metal heater has the following problems.

First, the thickness of the ceramic substrate must be as thick as about 15 mm since the heater is made of metal. This is because in a thin metal plate, a warp, a strain and the like are caused owing to thermal expansion thereof resulting from heating so that a silicon wafer placed on the metal plate is damaged or inclined. However, when the thickness of the ceramic substrate is made thick, a problem that the heater becomes heavy and bulky arises.

Heating temperature is controlled by changing the amount of voltage or electric current applied to the heating elements. However, since the metal plate is thick, the temperature of the ceramic substrate does not follow the change in the voltage or electric current amount promptly. Thus, a problem that the temperature is not easily controlled occurs.

On the contrary to this, JP Kokai Hei 11-40330 and the like discloses a ceramic heater wherein a nitride ceramic or carbide ceramic having a high thermal conductivity and a large strength is used instead of metal and heating elements formed by sintering metal particles are provided on a surface of a ceramic substrate made of such a ceramic.

Even when such a heater expands thermally at the time of heating, a warp, a strain or the like is not easily caused in its ceramic substrate. The temperature-following character to a change in applied voltage or electric current amount is also good.

### Summary of the Invention

However, in the process of producing a semiconductor, a corrosive gas such as chlorine-based gas or fluorine-based gas is used as an etching gas or a cleaning gas. Therefore, in the case where a ceramic heater having a structure as described above is used, there is caused a problem that electrode members such as external terminals, or conductive wires corrode so that the performance of the ceramic heater deteriorates.

In order to solve such a problem, a manner for protecting electrode members, such as external terminals or conductive wires, from corrosive gas and the like is adopted by: bonding a disc-shaped ceramic to a cylindrical ceramic body through a ceramic bonding layer; and providing external terminals and the like inside the cylindrical ceramic body, as described in JP Kokai Hei 2000-114355 or Japanese Patent gazette No. 2783980.

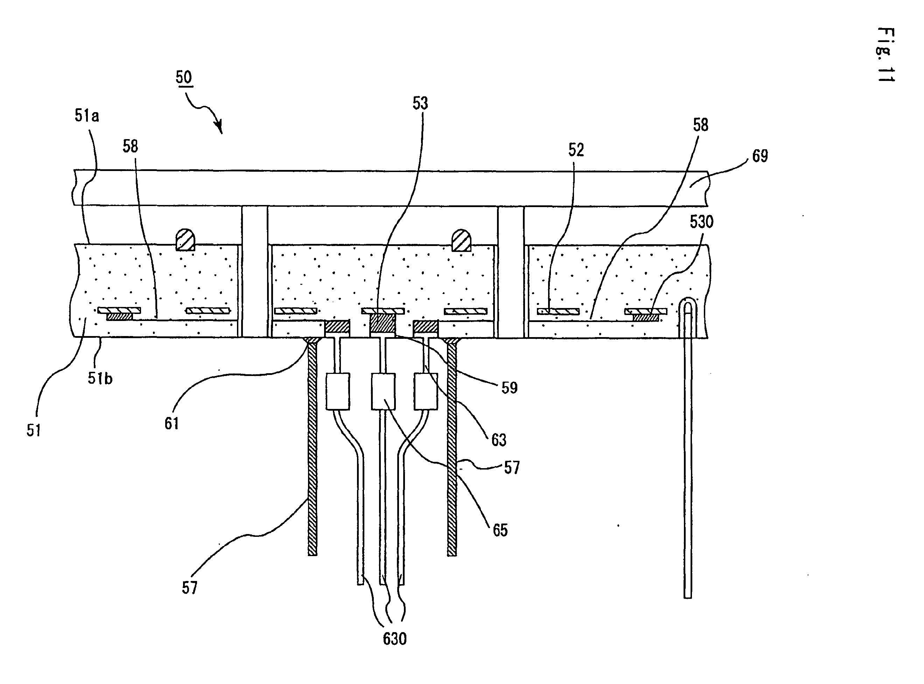

Fig. 11 is a sectional view schematically showing a ceramic heater wherein a silicon wafer is placed at a ceramic substrate having such a structure.

In this ceramic heater 50, a cylindrical body 57 is bonded to a bottom face 51b in the vicinity of the center of a ceramic substrate 51 having a disc shape through a ceramic bonding layer 61. Since the cylindrical ceramic body 57 is formed so as to adhere closely to a bottom plate (not shown) of a supporting case, the inside and outside of the cylindrical ceramic body 57 are completely isolated from each other.

A conductor circuit 58, which is extended toward the vicinity of the center of the ceramic substrate 51 at which the cylindrical ceramic body 57 is bonded, is formed between a resistance heating element 52 and the bottom face 51b, and the end portion of the resistance heating element is connected to one end portion of the conductor circuit 58 through a via hole 530.

This conductor circuit 58 is formed in order to extend the end portion of the resistance heating element to the central portion. Immediately under the other end portion of the conductor circuit 58 are formed a conductor-filled through hole 53 and a blind hole 59 for exposing the conductor-filled through hole 53. This conductor-filled through hole 53 is connected to an external terminal 63 having a T-shaped tip through a solder layer (not shown).

In the case where the end portion of the resistance heating element exists inside the cylindrical ceramic body 57, no via hole or conductor circuit is necessary. Consequently, the conductor-filled through holes 53 are directly formed at the end portions of the resistance heating element, and the end portions are connected to external terminals 63 through the solder layer.

Sockets 65 having conductive wires 630 are attached to these external terminals 63, and the conductive wires 630 are led out from a through hole (not shown) formed in a bottom plate (not shown), and are connected to a power source and the like (not shown).

As described above, in this ceramic heater 50, the cylindrical ceramic body 57 is bonded to the ceramic substrate 51 through the ceramic bonding layer 61, and the cylindrical ceramic body 57 is formed untill a bottom plate (case wall) of a non-shown supporting case; therefore, the inside and outside of the cylindrical ceramic body 57 are in the state that they are completely isolated from each other.

Accordingly, wires and the like inside the cylindrical ceramic body 57 are not corroded by corrosive gas and the like.

However, when this method is adopted, there is caused a new problem that temperature evenness in a heating face of the ceramic substrate deteriorates, resulted from escape of heat toward gas inside the cylindrical ceramic body by the introduction of inert gas or the like into the cylindrical ceramic body or escape of heat through a bonding portion for the ceramic substrate and the cylindrical ceramic body.

In light of above-mentioned problems, the present inventor made eager investigation to obtain a ceramic heater wherein: electrode members such as external terminals or conductive wires are not corroded, and dispersion in temperature in a heating face of a ceramic substrate is small, at the time of heating in the.process of producing a semiconductor. As a result, the present inventor has found out that, by: constituting a ceramic heater for a semiconductor producing/inspecting device wherein a resistance heating element is formed inside a ceramic substrate; and further forming a power feeding terminal at the outside of a wafer-heating region of the ceramic substrate, a portion forced to contact corrosive gas can be kept inside the wafer-heating region and thus a semiconductor wafer can be evenly heated without exposing external terminals or conductive bodies for connecting the external terminals to resistance heating elements to the corrosive gas. Thus, the present invention has been completed.

That is, a ceramic heater for a semiconductor producing/ inspecting device according to the present invention comprises: a ceramic substrate; and a resistance heating element formed inside the ceramic substrate, wherein a power feeding terminal is formed to be exposed at the outside of a wafer-heating region of the above-mentioned ceramic substrate.

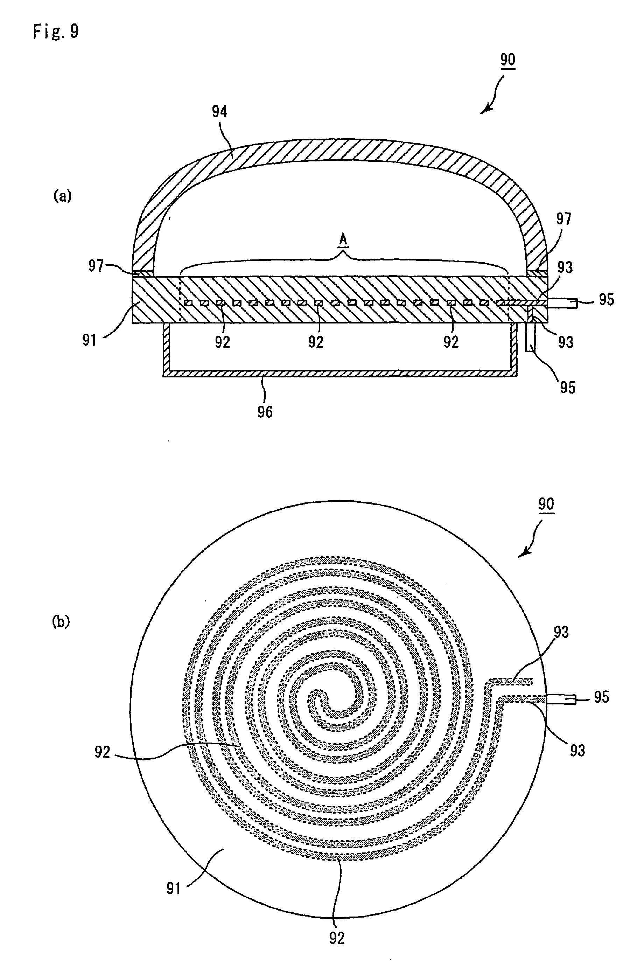

The wafer-heating region is desirably a portion extending from a face opposing a wafer, to a face opposite to the face opposing a wafer, of the ceramic substrate. That is, the above-mentioned wafer-heating region is a region used to heat a semiconductor wafer, and is desirably a portion (see Fig. 9) traversed in the process of dragging a place where the semiconductor wafer is to be placed, which is in a face opposing the semiconductor wafer of the ceramic substrate, to the underlying face (the face opposite to the face opposing the semiconductor wafer), vertically.

In a ceramic heater having a desired structure among the ceramic heaters for semiconductor producing/inspecting devices of the present invention, the above-mentioned ceramic substrate is constituted by: a disc-shaped substrate; and a convex portion formed on its side face, and the connection between the resistance heating element inside the above-mentioned ceramic substrate and an external terminal is made through a conductor inside the convex portion.

In another ceramic heater having a desired structure, the ceramic substrate is a disc-shaped substrate body having a diameter larger than the wafer-heating region thereof, and an external terminal is formed at the outside of the wafer-heating region.

It is desired that a bottomed hole is formed in a side face of the above-mentioned ceramic substrate and a temperature measuring element is inserted into the bottomed hole.

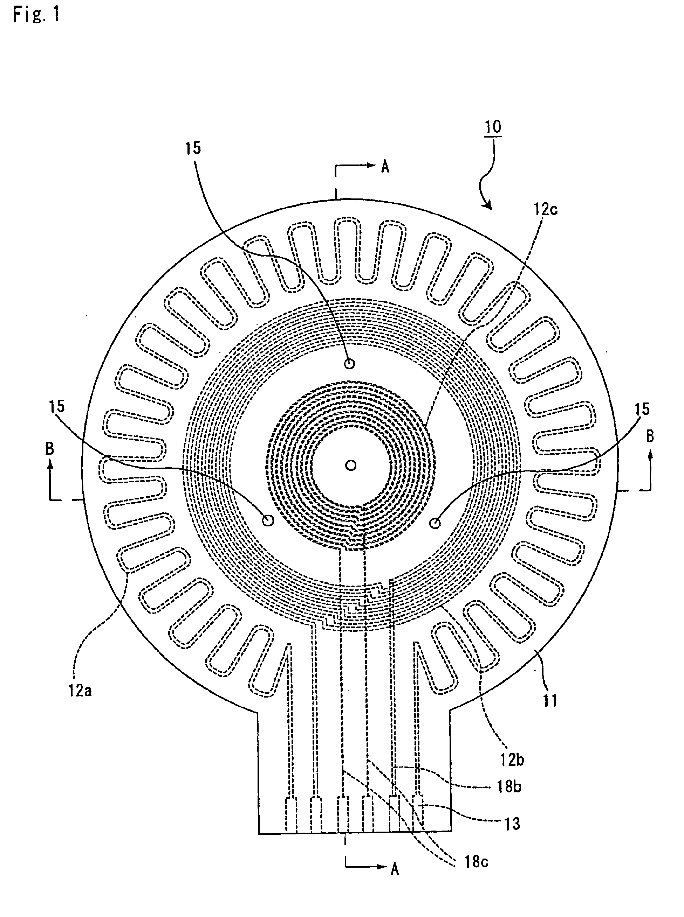

As shown in Figs. 1 to 3, in one of the ceramic heaters having the above-mentioned desired structures, its ceramic substrate has a shape wherein a disc-shaped substrate and a convex portion are formed to be integrated with each other, and the connection between a resistance heating element and an external terminal is made through a conductor inside the convex portion. Therefore, in the case where the ceramic heater is fixed to a supporting case and the resultant is used as a hot plate unit in the process of producing a semiconductor, electrode members such as the external terminal, and conductive wires can be arranged outside the atmosphere of corrosive gas. For this reason, the electrode members and the conductive wires are not forced to contact the corrosive gas, and a drop in the performance of the ceramic heater can be prevented.

Furthermore, even when in the ceramic heater of the present invention, the electrode members and the conductive wires cannot be arranged outside the corrosive gas atmosphere in the process of producing a semiconductor, the electrode members and the like are located to be concentrated in the vicinity of the convex portion of the ceramic substrate. Therefore, by forming a protective member made of a ceramic or the like capable of blocking the corrosive gas in this portion, the electrode members can easily be protected from the corrosive gas and the corrosion of the electrode members can be prevented.

In the ceramic heater of the present invention, it is unnecessary to provide the cylindrical ceramic body 57 for protecting electrode members such as external terminals, and conductive wires from corrosive gas, in the vicinity of the center portion of the ceramic substrate 51, as in the ceramic heater 50 shown in Fig. 11. Therefore, it is unnecessary to consider: temperature unevenness in the heating face, which is resulted from: escape of heat toward the gas inside the cylindrical ceramic body 57 by the introduction of inert gas or the like into the cylindrical ceramic body 57; or escape of heat through a bonding portion for the ceramic substrate 51 and the cylindrical ceramic body 57, and thus a semiconductor wafer, which is an object to be heated, can be evenly heated.

In a ceramic heater having another structure, its ceramic substrate is a disc-shaped substrate body having a diameter larger than the wafer-heating region thereof, wherein an external terminal is formed at the outside of the wafer-heating region.

In this structure, it is sufficient as long as a chamber is formed so as to cover the ceramic substrate. Also, if the terminal is made exposed from a side face of the ceramic substrate, a conductive wire for connecting the resistance heating element to the terminal is not corroded by any corrosive gas since the conductive wire exists inside the ceramic substrate.

Also, since the ceramic heater is a single disc as a whole, the heat capacity can be made point-symmetric as compared with the case of forming the convex portion. Thus, radiation of heat is evenly performed and, this structure is favorable. The diameter of the ceramic substrate is desirably set to not less than 1.5 times larger than the wafer-heating region.

### Brief Description of the Drawings

Fig. 1 is a bottom view schematically showing one example of a ceramic heater according to the present invention.
Fig. 2 is a partial sectional view of the ceramic heater shown in Fig. 1 taken in the direction of A-A line.
Fig. 3 is a partial sectional view of the ceramic heater shown in Fig. 1 taken in the direction of B-B line.
Fig. 4 is a bottom view schematically showing another example of the ceramic heater according to the present invention.
Fig. 5 is a sectional view schematically showing one example of the case where the ceramic heater according to the present invention is fixed to a supporting case.
Fig. 6 is a partial sectional view schematically showing one example of the case where a protective member is formed in the ceramic heater according to the present invention.
Fig. 7 is a bottom view schematically showing a structure of bottomed holes in the ceramic heater shown in Fig. 1 and temperature measuring elements.
Fig. 8 is a plan view showing a ceramic heater having a convex portion of a semicircular shape.
Figs. 9 are bottom views schematically showing another embodiment of the ceramic heater according to the present invention.
Figs. 10(a) to (d) are sectional views schematically showing parts of the process of producing the ceramic heater shown in Fig. 1.
Fig. 11 is a sectional view schematically showing one example of a conventional ceramic heater.
Fig. 12(a) is a thermoviewer photograph obtained by observing the heating face of the ceramic heater according to Example 1, and Fig. 12 (b) is a thermoviewer photograph obtained by observing the heating face of the ceramic heater according to Comparative Example 1.
Fig. 13 is a graph showing the relationship between the in-face temperatures and the thermal conductivities thereof of the ceramic heater according to Examples 4 to 8 and Comparative Examples 2 to 6.
Fig. 14 is a graph showing the relationshipbetween applied electric powers and temperatures in the case where the temperatures of the ceramic heaters according to Example 1 and Comparative Example 1 were raised.

| | Explanation of Symbols |
|---|---|
| 10, 30, 50 | ceramic heater |
| 11, 31, 51 | ceramic substrate |
| 11a, 51a | heating face |
| 11b, 51b | bottom face |
| 12, 32, 52 | resistance heating element |
| 120, 180 . | conductor containing paste layer |
| 23, 63 | external terminal |
| 14, 54 | bottomed hole |
| 15, 55 | through hole for a lifter pin |
| 16, 56 | lifter pin |
| 18, 58 | conductor circuit |
| 20 | protective member |
| 21 | bonding layer |
| 13, 53 | conductor-filled through hole |
| 130, 170 | filled layer |
| 29, 69 | semiconductor wafer |
| 70 | green sheet |

### Detailed Disclosure of the Invention

The following will describe the present invention according to embodiments thereof.

A ceramic heater for a semiconductor producing/inspecting device according to an embodiment is a ceramic heater for a semiconductor producing/inspecting device wherein resistance heating elements comprising a plurality of circuits are formed inside a ceramic substrate, in which the ceramic substrate is formed of a disc-shaped substrate and a convex portion of a substantially rectangular shape, these are integrated to constitute a main face on a single plane, and the connection between the resistance heating elements and external terminals is made at a side face of the convex portion.

The embodiment of the ceramic heater of the present invention will be described with reference to drawings.

In the following description, a ceramic heater for a semiconductor producing/inspecting device may be referred to simply as a ceramic heater.

Fig. 1 is a bottom view which schematically shows a ceramic heater of the present invention.

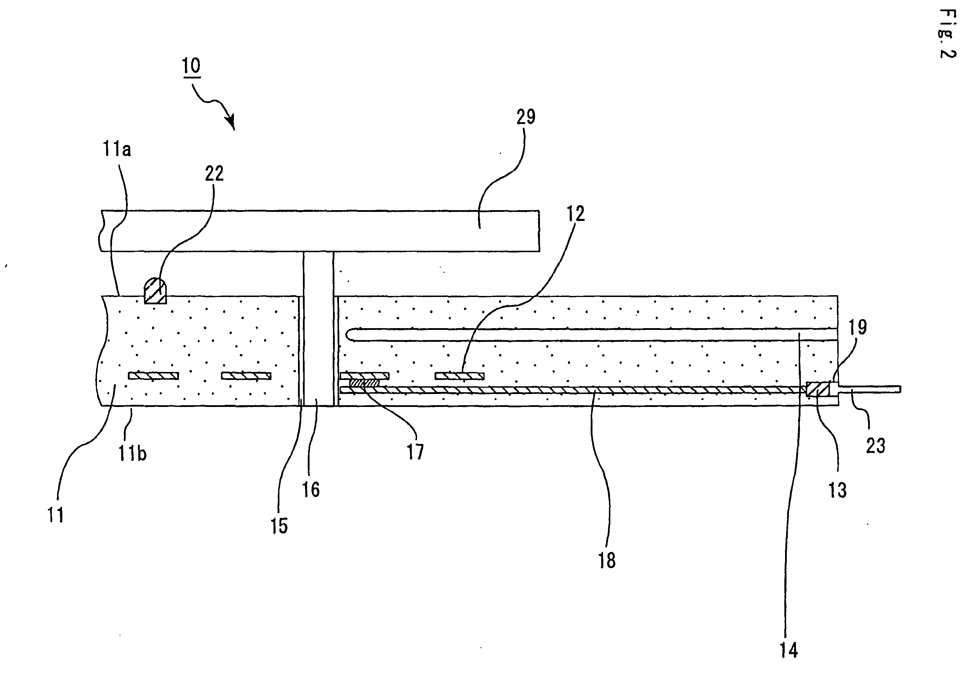

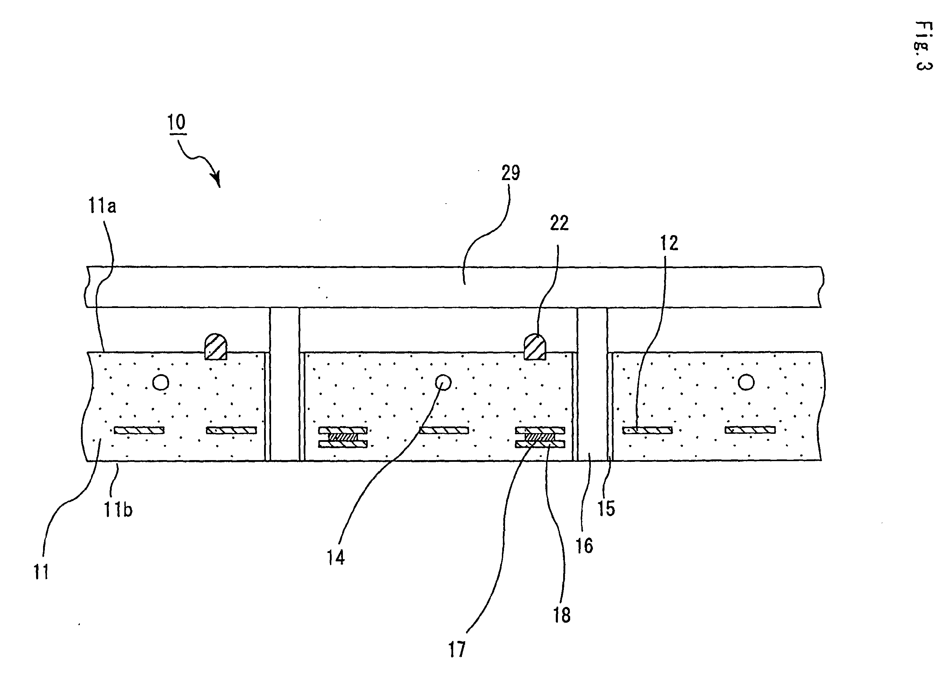

Fig. 2 is a partial sectional view of the ceramic heater shown in Fig. 1 taken in the direction of A-A line, and Fig. 3 is a partial sectional view of the ceramic heater shown in Fig. 1 taken in the direction of B-B line.

In this ceramic heater, resistance heating elements are formed inside its ceramic substrate.

In the following description, the A-A line direction and the B-B line direction may be referred to as the longitudinal direction and the lateral direction, respectively.

As shown in Fig. 1, in the ceramic heater 10, its ceramic substrate 11 has a shape formed of a disc-shaped substrate and a convex portion of a substantially rectangular shape.

The disc-shaped substrate and the convex portion of a substantially rectangular shape are integrated with each other to constitute a main face on a single plane. The thickness of side faces of the ceramic substrate 11 is wholly even.

In the following description, the convex portion of a substantially rectangular shape may be referred to simply as the convex portion. The shape of the convex portion is not limited to any rectangular shape, and may be a semicircular and the like.

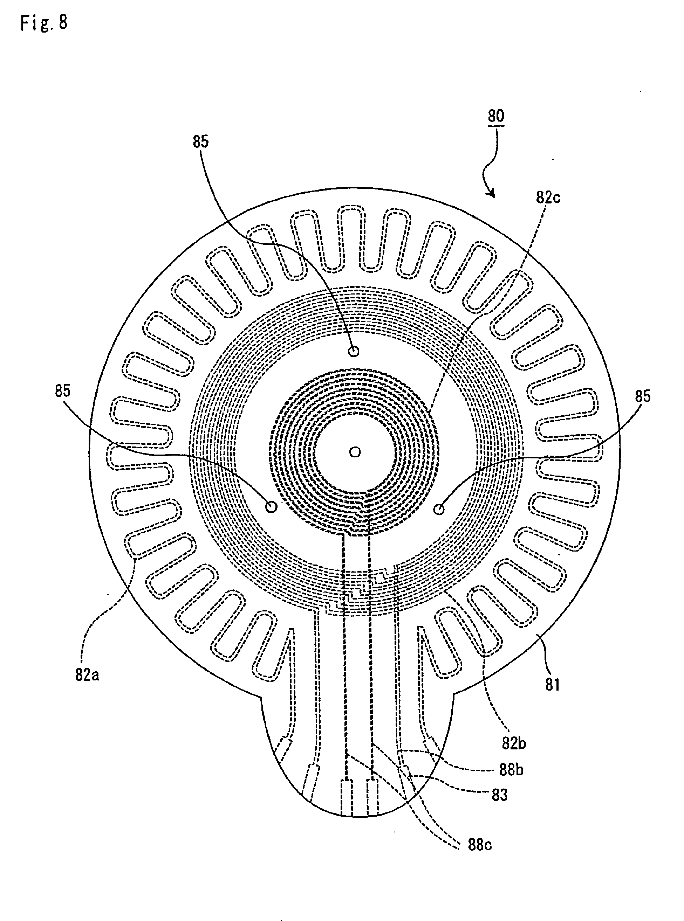

Fig. 8 shows a ceramic heater 80 having a convex portion of a semicircular shape. This ceramic heater 80 is constructed in the same manner as the ceramic heater 10 shown in Fig. 1 except that the convex portion has a semicircular shape.

The diameter of the disc-shaped substrate which constitutes the ceramic substrate 11 in the ceramic heater 10 of the present invention is desirably 200 mm or more. This is based on the following reasons: as the ceramic heater has a larger diameter, the temperature of a semiconductor wafer 29 easily becomes more uneven when the wafer is heated, and thus the construction of the present invention functions more effectively; and also a semiconductor wafer having a large diameter can be placed on the substrate having such a large diameter.

In particular, the diameter of the substrate which constitutes the ceramic substrate 11 is desirably 12 inches (300 mm) or more. This is because, this size becomes the main current of semiconductor wafers in the next generation.

About the substantially rectangular convex portion of the ceramic substrate 11, the length thereof in the A-A line direction (longitudinal direction) is desirably 310 to 600 mm.

If the length is less than 310 mm, electrode members cannot be arranged outside the atmosphere of corrosive gas since the distance between the semiconductor wafer 29 and the electrode members cannot be made sufficiently long. When the length exceeds 600 mm, the temperature of the convex portion drops so that dispersion in temperature is generated in the heating face of the ceramic substrate 11.

On the other hand, the length in the B-B line direction (lateral direction) of the convex portion is desirably 5 to 340 mm.

When the length is less than 5 mm, it is difficult to form resistance heating elements 12 or external terminals 23 in the convex portion. When the length exceeds 340 mm, the interval between the resistance heating elements 12 is too wide in the convex portion so that the temperature of the convex portion drops. Consequently, dispersion in temperature is caused in the heating face of the ceramic substrate 11.

The thickness of the ceramic substrate 11 which constitutes the ceramic heater 10 of the present invention is desirably 25 mm or less. This is because when the thickness of the ceramic substrate 11 exceeds 25 mm, the temperature-following character deteriorates. Moreover, the thickness is desirably 0.5 mm or more. When the thickness is smaller than 0.5 mm, the strength itself of the ceramic substrate 11 drops so that the ceramic substrate is easily damaged. Moreover, it is difficult to form via holes or conductor circuits 18 under the resistance heating elements 12.

More desirably, the thickness exceeds 1.5 mm and 5 mm or less. When the thickness is larger than 5 mm, heat is not easily conducted so that heating efficiency tends to deteriorate. On the other hand, when the thickness is 1.5mm or less, heat conducted in the ceramic substrate 11 does not diffuse sufficiently so that dispersion in temperature may be caused in the heating face. Additionally, the strength of the ceramic substrate 11 drops so that the ceramic substrate 11 may be damaged.

Furthermore, in the ceramic substrate 10, the resistance heating elements 12 (12a to 12c) are formed inside the ceramic substrate 11 in order to perform heating in such a manner that the temperature in the whole of the heating face 11a will be even.

That is, a resistance heating element 12a having a repetition pattern of winding lines is arranged in the outermost circumference of the ceramic heater 10, and resistance heating elements 12b and 12c including circuits of concentrically circular patterns are arranged at a constant intervals and inside the resistance heating element 12a.

As the pattern of the resistance heating element 12a in the outermost circumference in the ceramic heater 10 of the present invention, there can be used, for example, a concentrically circular pattern, a spiral pattern, an eccentrically circular pattern or the like as well as the repetition pattern of the winding lines, shown in Fig. 1. Also, these may be used together.

By making the pattern of the resistance heating element 12a formed in the outer circumference as a pattern divided in the circumferential direction, minute temperature control can be performed in the outermost circumference, where the temperature drops easily, of the ceramic heater 10. Thus, dispersion in the temperature of the ceramic heater 10 can be suppressed. Furthermore, the pattern of the resistance heating elements divided in the circumferential direction may be formed not only in the outermost circumference but also in the inside thereof.

About the resistance heating elements 12b and 12c formed in the internal circumference portion of the ceramic substrate 11, there can also be used, for example, repetition patterns of winding lines, spiral patterns, eccentrically circular patterns or other patterns besides the concentrically circular patterns.

In the ceramic heater 10, each of end portions of the resistance heating elements 12a to 12c is extended to a side face of the convex portion of the ceramic substrate 11.

The pattern of resistance heating element 12a is as follows: a part of the repetition pattern of the winding lines is cut such that end portions of the two cut ends are extended perpendicularly to the side face of the convex portion of the ceramic substrate 11.

In the resistance heating element 12b, one of the end portions thereof is formed at the outer side of the concentrically circular pattern, and the end portion is extended perpendicularly to the side face of the convex portion of the ceramic substrate 11 in the same manner as in the case of the resistance heating element 12a. Whereas, the other end portion is formed at the inner side of the concentrically circular pattern in order to prevent the generation of cooling spots and the like. Hence, a via hole 17 is made immediately under this end portion, and a conductor circuit 18b is formed under the via hole 17, whereby the end portion of the resistance heating element is extended to the side face of the convex portion of the ceramic substrate 11.

At the resistance heating element 12c, via holes 17 are formed immediately under the end portion thereof at the outer side of the concentrically circular pattern and the end portion thereof at the inner side thereof, and a conductor circuit 18c is formed under the via holes 17, whereby the end portions of the resistance heating element are extended to the side face of the convex portion of the ceramic substrate 11.

That is, the end portions formed at the inner side of the concentrically circular patterns are connected to the conductor circuits 18b and 18c through the via holes 17.

In order to prevent intervals between the resistance heating elements from being sparse in the vicinity of the bonding part between the disc-shaped substrate and the substantially rectangular convex portion of the ceramic substrate 11, the cut portion of the repetition pattern of the winding lines, which is the resistance heating element 12a formed in the outer circumference, may be made narrower than the one shown in the figure.

In order to avoid overlapping of the repetition pattern of the winding lines with the conductor circuit 18b or 18c three-dimensionally in this case, a via hole may be made immediately above the cut portion at the repetition pattern of the winding lines, thereby forming conductor circuits having a structure wherein end portions are extended from the upper part of this via hole as a starting point to the side face of the convex portion such that the cut portion of the repetition pattern of the winding lines becomes narrow.

The conductor circuits 18 are formed in order to extend the end portions of the resistance heating elements to the side face of the convex portion of the ceramic substrate 11. About the material, the structure and so on of the conductor circuits 18, it is desired to use the same as those of the resistance heating elements 12.

In the ceramic heater of the present invention, the resistance heating elements 12 are formed inside the ceramic substrate 11 so that the surfaces of the resistance heating elements are not oxidized. Thus, it is unnecessary to cover the surface.

Furthermore, conductor-filled through holes 13 are formed at the end portions of the conductor circuits 18 and the end portions of the resistance heating elements extended to the side face of the convex portion of the ceramic substrate 11, and blind holes for making the conductor-filled through holes exposed are formed. Moreover, external terminals 23 are inserted into the blind holes 19, and they are bonded with a brazing material (not shown).

Furthermore, for example, sockets (not shown) having conductive wires are attached to the external terminals 23, and the conductive wires are connected to a power source or the like.

The external terminals 23 equipped for the connection to the power source are attached to the resistance heating elements 12 through solder. In the case where the external terminals 23 are connected thereto, an alloy such as silver-lead, lead-tin or bismuth-tin can be used as the solder. The thickness of the solder layer is desirably 0.1 to 50 µm. This is because this range is a range sufficient for maintaining the connection based on the solder.

Examples of the external terminals 23 include external terminals made of kovar or Ni.

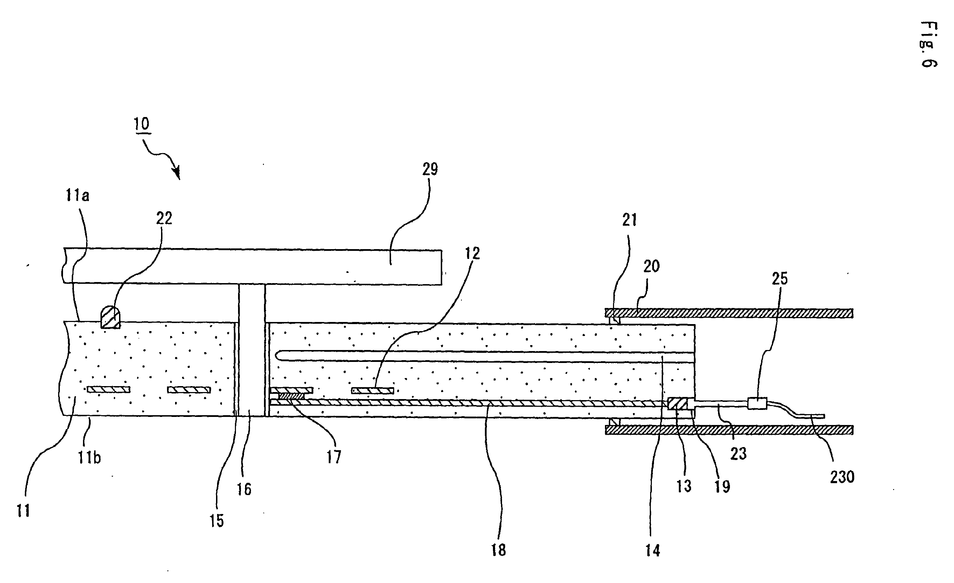

The external terminals 23 are desirably formed on a side face or a lower side face of the ceramic substrate, as shown in Fig. 6.

As shown in Figs. 2 and 3, through holes 15 are formed in the ceramic substrate 10 and, also, lifter pins are passed through the through holes 15 so that the semiconductor wafer 29, which is an object to be heated, can be supported and heated in the state where the wafer 29 is positioned a predetermined distance apart from the heating face of the ceramic heater 10.

By not the lifter pins 16 but supporting pins 22 formed on the heating face of the ceramic heater, the semiconductor wafer 29 can be supported and heated in the state that the wafer 29 is positioned a predetermined distance apart from the heating face of the ceramic heater 10.

In the ceramic substrate 11 of the present invention, when the semiconductor wafer 29, which is an object to be heated, is positioned apart from the heating face of the ceramic substrate 11 by means of the lifter pins 15 or the supporting pins 22, it is desired to hold the wafer 29 in the state where the wafer 29 is positioned 5 to 5000 µm apart. This is because: when the distance is less than 5 µm, the distance becomes too short, thus the temperature of the semiconductor wafer is affected by temperature distribution in the ceramic substrate 11 and made uneven.

When the distance exceeds 5000 µm, the temperature of the semiconductor wafer 29 does not rise easily. As a result, in particular, the temperature of the outer circumferential portion of the semiconductor wafer 29 becomes low. The object to be heated and the heating face of the ceramic substrate are desirably positioned from 5 to 500 µm, more desirably from 20 to 200 µm apart from each other.

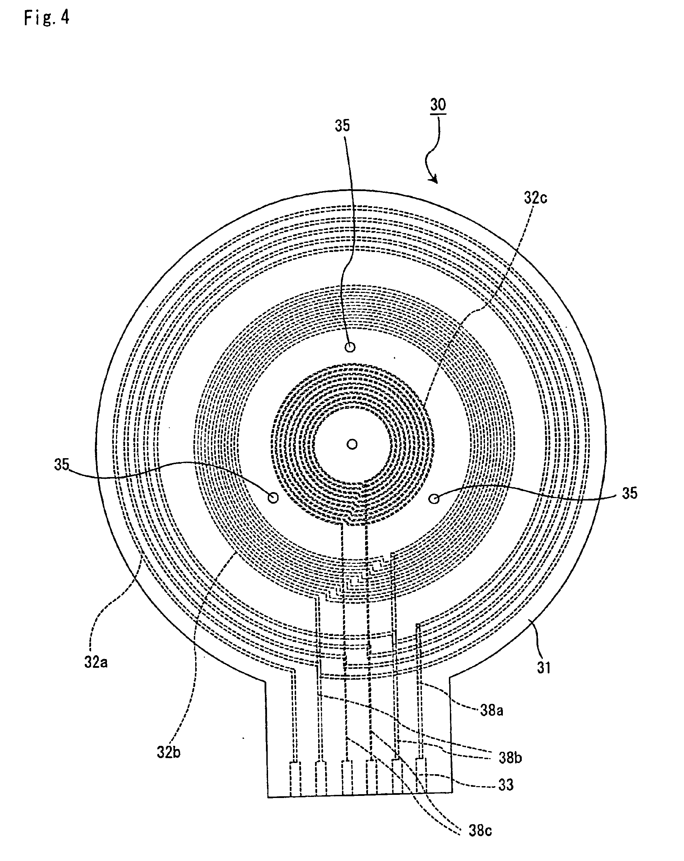

Fig. 4 is a bottom view which schematically shows a ceramic heater of another embodiment of the present invention.

In the ceramic heater 30, resistance heating elements 32 (32a to 32c) are formed inside a ceramic substrate 31 so as to perform heating in such a manner that the temperature in the whole of a heating face 31a will be even. These resistance heating elements 32a to 32c are formed of circuits having concentrically circular patterns. Each of the end portions of the resistance heating elements 32a to 32c is extended to a side face of a convex portion of the ceramic substrate 31.

The end portion formed at the outer side of the resistance heating element 32a, which is one of the concentrically circular patterns, is extended perpendicularly to the side face of the convex portion of the ceramic substrate 31. A via hole is formed immediately under the end portion formed at the inner side, and a conductor circuit 38a is formed, through the via hole, immediately under the end portion, whereby the end portion of the resistance heating element is extended to the side face of the convex portion of the ceramic substrate 31.

In the resistance heating elements 32b and 32c, via holes are formed immediately under the end portions formed at the outer sides of the concentrically circular patterns and the end portions formed at the inner sides thereof, and conductor circuits 38b and 38c are formed under the via holes, thereby extending the end portions of the resistance heating elements to the side face of the convex portion of the ceramic substrate 31.

About the ceramic substrate 30 shown in Fig. 4, structures other than the patterns of the resistance heating elements are similar to that in the ceramic substrate 10 shown in Fig. 1. Thus, description thereof will not be repeated.

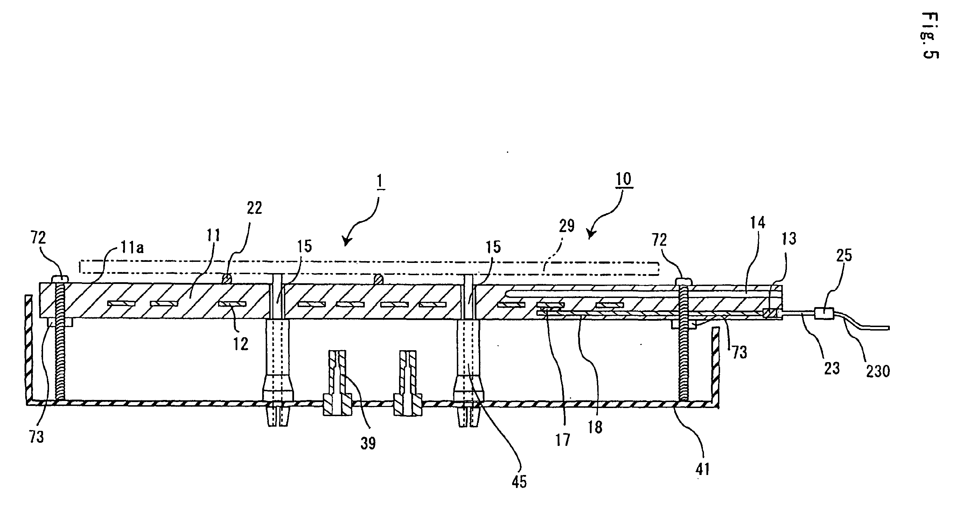

Fig. 5 is a sectional view which schematically shows one example of the case where the ceramic heater 10 of the present invention is fixed to a supporting case to function as a hot plate unit.

In the hot plate unit 1, through holes are formed near the outer circumference portion of the ceramic heater 10, and bolts 72 are passed through the through holes. Ends of the bolts 72 are fixed to the bottom of the supporting case and, also, the bolts are fixed by means of nuts 73 erected to the lower part of the ceramic substrate 11. Consequently, the ceramic heater 10 is supported and fixed to the inside of the supporting case 41 by means of the bolts 72 which are vertically erected on the bottom of the supporting case 41.

In this case, the substantially rectangular convex portion of the ceramic substrate 11 is positioned outside the upper part of the supporting case.

The ceramic heater 10 is supported and fixed at the bottom of the supporting case 41 in substantially parallel manner with each other.

Furthermore, in this state, the side faces of the ceramic heater 10 and an outer frame portion of the supporting case 41 are slightly separated to be brought into a non-contact state with each other. Since the air functions as a heat insulating material, heat does not escape easily from the side faces of the ceramic heater 10.

External terminals 23 are connected through a solder layer (not shown) to the end portions of the conductor circuits 18 which is connected through the via holes 17 to the resistance heating elements 12. Sockets 25 having conductive wires 230 are attached to the external terminals 23, and the conductive wires 230 are led out from the supporting case, so as to be connected to a power source (not shown).

Incidentally, guide tubes 45 for protecting lifter pins (not shown) are formed in the hot plate unit 1, and coolant introducing pipes 39 are fixed to the bottom portion of the supporting case 41 to make cooling possible.

In the case where the ceramic heater 10 of the present invention is used as the hot plate unit 1 having the structure shown in Fig. 5 in the process of producing a semiconductor, the distance from a semiconductor wafer 29 to electrode members such as the external terminals 23 and the like, or the conductive wires 230 can be made long; therefore, the electrode members, such as the external terminals 23 formed at the side face of the convex portion of the ceramic substrate 11, and the conductive wires 230 can be provided outside the atmosphere of corrosive gas such as cleaning gas by putting the whole of the hot plate unit except the convex portion into an air-tightly closed case or by covering only the convex portion with a protective member or the like. Thus, the electrode members are not forced to contact the corrosive gas, and deterioration in the performance of the ceramic heater can be prevented.

Additionally, in the ceramic heater of the present invention, it is unnecessary to set, in the vicinity of the central portion of the ceramic substrate, any cylindrical ceramic body for protecting the electrode members such as the external terminals, or the conductive wires from the corrosive gas, as performed in the ceramic heater shown in Fig. 11. It is therefore unnecessary to consider temperature unevenness in the heating face, resulting from escape of heat toward the gas inside the cylindrical ceramic body by the introduction of inert gas or the like into the cylindrical ceramic body or escape of heat through a bonding portion for the ceramic substrate and the cylindrical ceramic body. Thus, the semiconductor wafer, which is an object to be heated, can be evenly heated.

Besides, it is unnecessary to produce a ceramic sintered body and subsequently perform the step of bonding the ceramic substrate to any cylindrical ceramic body by re-firing or some other operation as performed in the ceramic heater 50 of Fig. 11. Thus, the process of producing the ceramic heater can be made simple.

Fig. 6 is a sectional view which schematically shows a structure in the case where electrode members such as external terminals 23 and the like, or conductive wires, which are formed on a side face of a convex portion of a ceramic substrate 11, are covered with a protective member 20.

The protective member 20 is desirably made of a material having an insulating property and having such a heat-resistance that the member is not deformed or reformed even when the ceramic substrate 11 is heated, and is desirably a member made of an oxide ceramic such as alumina, silica, mullite or cordierite, a nitride ceramic such as aluminum nitride or silicon nitride, a carbide ceramic such as silicon carbide, a corrosion-resistant metal, or the like.

The protective member 20 is desirably brazed to the ceramic substrate 11 through a bonding portion 21 made of a brazing material. This is because the ceramic substrate 11 and the protective member 20 are firmly fixed to each other. Thematerial of the bonding portion 21 is not particularly limited, and examplesthereofinclude brazing aluminum,brazing gold,brazing silver, brazing phosphor copper, brazing brass, brazing nickel and brazing palladium.

Further, a heat insulating ring may be used in the bonding portion 21.

As the bonding portion 21, the following may be used: brazing silver prescribed in JIS Z 3261-1976, brazing gold prescribed in JIS Z 3266-1977, brazing palladium prescribed in JIS Z 3267-1976, brazing brass prescribed in JIS Z 3262-1977, brazing aluminum alloy prescribed in JIS Z 3263-1977, brazing phosphor copper prescribed in JIS Z 3264-1977 , brazing phosphor nickel prescribed in JIS Z 3265-1976, or the like.

Specifically, an example of brazing silver is an alloy made of 44 to 46% by weight of Ag, 14 to 16% by weight of Cu, 14 to 18% by weight of Zn, and 23 to 35% by weight of Cd, an example of brazing gold is an alloy made of 34.5 to 35.5% by weight of Au, and 2.5 to 3.5% by weight of Ni, an example of brazing palladium is an alloy made of 59.5 to 60.5% by weight of Pd, and 39.5 to 40.5% by weight of Ni, and an example of brazing brass is an alloy made of 46 to 49% by weight of Cu, 10 to 11% by weight of Ni, and 0.3 to 1.0% by weight of Ag.

An example of brazing aluminum alloy is an alloy made of 0.25% or less by weight of Cu, 6.8 to 8.2% by weight of Si, 0.1% or less by weight of Mn, 0.8% or less by weight of Fe and the balance of Al, an example of brazing nickel is an alloy made of 13.0 to 15.0% by weight of Cr, 2.7 to 4.0% by weight of B, 3. 0 to 5.0% by weight of Si, 4.0 to 5.0% by weight of Fe, 0.6 to 0.9% by weight of C, and the balance of Ni, and an example of brazing phosphor copper is an alloy made of 4.8 to 5.3% by weight of P, and the balance of Cu.

The thickness of the bonding portion 21 is desirably 0.1 to 5 mm. This is because, if the thickness is too large or too small, the adhesiveness becomes poor.

Accordingly, even when the whole of the hot plate unit 1 including the electrode members such as the external terminals 23, or the conductive wires 230 is in the atmosphere of corrosive gas in the process of producing a semiconductor, the electrode members, such as the external terminals 23, or the conductive wires 230 can easily be protected from the corrosive gas and corrosion of the electrode members and the conductive wires can be prevented by covering the electrode members and the conductive wires 230 with the protective member 20 capable of blocking the corrosive gas as shown in Fig. 6 since the electrode members such as the external terminals 23 concentrate in the vicinity of the convex portion of the ceramic substrate 11 in the ceramic heater 10 of the present invention.

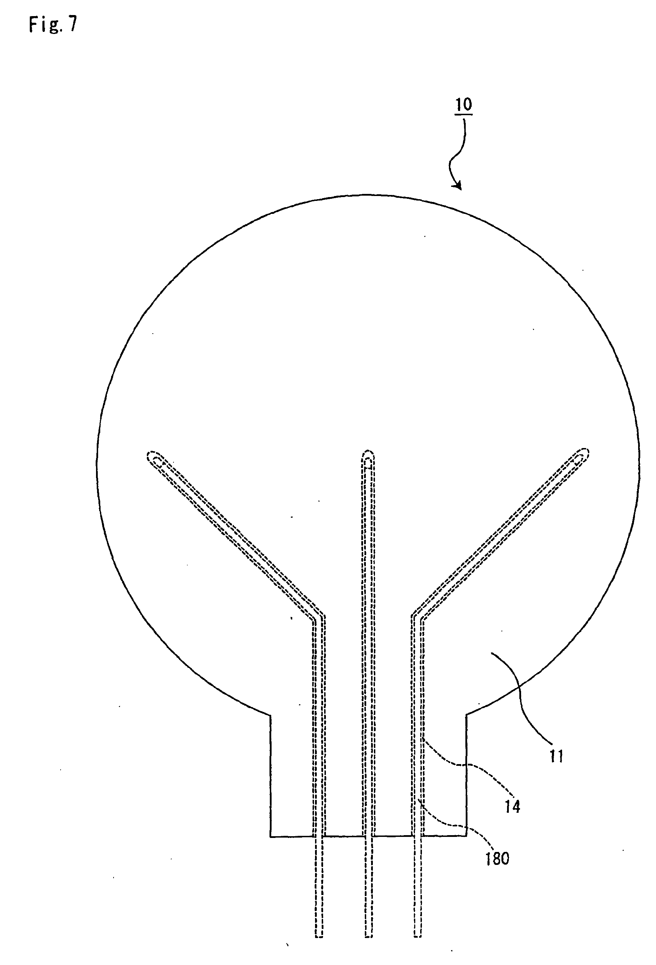

Fig. 7 is a bottom view which schematically shows a structure of bottomed holes formed in the ceramic substrate 11, and the like.

As shown in Fig. 7, the plurality of bottomed holes 14, which are in parallel to the main face of the ceramic substrate 11 and have openings in the side face of the convex portion, are formed in the ceramic substrate 11.

Temperature measuring elements 180 are inserted in the bottomed holes 14.

The bottomed holes 14 are formed in such a manner that their tips are positioned in portions the temperature of which relatively easily becomes uneven, such as the central portion of the ceramic substrate 11 and the outer circumference portion thereof. Therefore, in the case where the temperature measuring elements 180 are inserted into the bottomed holes 14 to measure the temperature of the ceramic substrate, the temperature in the heating face can be precisely measured.

As shown in Figs. 2 and 3, the temperature in the heating face can be more precisely measured by making the bottomed holes 14 closer to the heating face 11a than the resistance heating elements 12.

The openings of the bottomed holes 14 are provided in the side face of the convex portion of the ceramic substrate 11; therefore, portions where the temperature measuring elements 180 are exposed can be positioned outside the corrosive gas atmosphere, in the process of producing a semiconductor, in the same manner as in the case of the above-mentioned electrode members and conductive wires. The portions where the temperature measuring elements 180 are exposed are not forced to contact the corrosive gas. Thus, deterioration in the performance of the temperature measuring elements 180 can be prevented.

The distance between the bottomed holes 14 and the heating face 11a is desirably 0.1 mm to 1/2 of the thickness of the ceramic substrate.

With this structure, temperature-measuring positions are closer to the heating face 11a than the resistance heating elements 12, so that the temperature of the semiconductor wafer 29 can be more precisely measured.

When the distance between the bottomed holes 14 and the heating face 11a is less than 0.1 mm, heat radiates so that a temperature distribution is formed in the heating face 11a. When the distance exceeds 1/2 of the thickness, the ceramic substrate is easily affected by the temperature of the resistance heating elements 12 so that temperature-control cannot be performed. Thus, a temperature distribution is formed in the heating face, as well.

The diameter of the bottomed hole 14 is desirably 0.3 to 5 mm. This is because, when the diameter is too large, the heat-radiating property becomes large. When the diameter is too small, the processability deteriorates so that the distance to the heating face 11a cannot be made even.

As shown in Fig. 7, a plurality of the bottomed holes 14 are desirably arranged linear-symmetrically with the center of the ceramic substrate 11. This is because temperatures in the entire heating face can be measured.

Examples of the temperature measuring elements 180 include thermocouples, platinum temperature measuring resistors, thermistors and the like.

Examples of the thermocouple include K-, R-, B-, S-, E-, J- and T-type thermocouples and the like, as described in JIS-C-1602 (1980). Of these, the K-type thermocouple is preferred.

Desirably, the size of the connecting part of the thermocouple is equal to or more than the strand diameter thereof, and is 0.5 mm or less. This is because when the connecting part is large, the heat capacity is large so that the responsibility deteriorates. It is difficult to make the size thereof smaller than the strand diameter.

The above-mentioned temperature measuring elements 180 may be bonded to the bottom of the bottomed holes 14 with brazing gold, brazing silver or the like, or may be inserted into the bottomed holes 14 followed by sealing up the holes with a heat-resistant resin. The two may be used together.

Examples of the heat-resistant resin include thermosetting resins, in particular, epoxy resin, polyimide resin and bismaleimide-triazine resin and the like. These resins may be used alone or in combination of two or more of them.

As the above-mentioned brazing gold, desired is at least one selected from an alloy of 37 to 80.5% by weight of Au and 63 to 19.5% by weight of Cu, and an alloy of 81.5 to 82.5% by weight of Au and 18.5 to 17.5% by weight of Ni. These have a melting temperature of 900°C or more, and are not easily melted in high temperature regions.

Examples of the brazing silver include Ag-Cu types.

The following will describe the material, shape and so on of the ceramic heater which constitutes the present invention in more detail.

The ceramic which constitutes the ceramic heater of the present invention is desirably a nitride ceramic or a carbide ceramic.

Since a nitride ceramic or a carbide ceramic has a thermal expansion coefficient smaller than metals and a far higher mechanical strength than metals, the ceramic substrate thereof does not warp or bend even when the thickness of the ceramic substrate is made small. Therefore, the ceramic substrate can be made thin and light. Since the thermal conductivity of the ceramic substrate is high and the ceramic substrate itself is thin, the surface temperature of the ceramic substrate follows temperature change in the resistance heating elements promptly. That is, the surface temperature of the ceramic substrate can be controlled by changing the amount of voltage or electric current to change the temperature of the resistance heating elements.

Examples of the nitride ceramic include aluminum nitride, silicon nitride, boron nitride and titaniumnitride and the like. These may be used alone or in combination of two or more.

Examples of the carbide ceramic include silicon carbide, zirconium carbide, titanium carbide, tantalum carbide and tungsten carbide. These may be used alone or in combination of two or more.

Of these, aluminum nitride is most preferred. This is because its thermal conductivity is highest, that is, 180 W/m· K and aluminum nitride has excellent temperature-following character.

It is desired that the ceramic substrate of the present invention contains carbon and the carbon content is from 200 to 5000 ppm. This is because the electrodes can be concealed and black-body radiation is easily used.

The brightness of the ceramic substrate is desirably N6 or less as a value based on the rule of JIS Z 8721. This is because the ceramic having such a brightness is excellent in radiant heat capacity and the property of the concealing.

The brightness N is defined as follows: the brightness of ideal black is made to 0; that of ideal white is made to 10; respective colors are divided into 10 parts in the manner that the brightness of the respective colors is recognized stepwise between the brightness of black and that of white; and the resultant parts are indicatedby symbols N0 to N10, respectively.

Actual measurement thereof is performed by comparison with color charts corresponding to N0 to N10. One place of decimals in this case is made to 0 or 5.

In the present invention, the resistance heating elements are embedded in the ceramic substrate.

When the resistance heating elements are formed inside the ceramic substrate, it is desired that the resistance heating elements are formed at positions having a distance, from the face opposite to the heating face, of 60% or less of the thickness. In the case of exceeding 60%, heat conducted in the ceramic substrate does not diffuse sufficiently since the resistance heating elements are too near to the heating face. Thus, a temperature distribution in the heating face is generated.

When the resistance heating elements are formed, a plurality of heating element forming layers may be provided. In this case, the patterns of the respective layers are desirably in the state where any one of the resistance heating elements is formed on some layer so as to be complementary to each other and, when viewed from a position above the heating face, the patterns are formed in all areas. An example of such a structure is a staggered arrangement.

When the resistance heating elements are formed inside the ceramic substrate, the thickness thereof is preferably 1 to 50 µm. The width of the resistance heating elements in the ceramic substrate is preferably 5 to 20 µm.

The resistance value of the resistance heating elements can be changed dependently on their width or thickness. The above-mentioned ranges are however most practical. The resistance value becomes larger as the resistance heating elements become thinner and narrower. The thickness and the width of the resistance heating elements become larger in the case where the resistance heating elements are formed inside the ceramic substrate. However, when the resistance heating elements are formed inside, the distance between the heating face and the resistance heating elements becomes short so that the evenness of the temperature in the surface deteriorates. Thus, it is necessary to make the width of the resistance heating elements themselves large. Since the resistance heating elements are formed inside, it is unnecessary to consider the adhesiveness to the nitride ceramic or the like. Therefore, it is possible to use a high melting point metal such as tungsten or molybdenum, or a carbide of tungsten, molybdenum or the like. Thus, the resistance value can be made high. Therefore, the thickness itself may be made large in order to prevent disconnection and the like. For these reasons, the resistance heating elements are desirably made to have the above-mentioned thickness and width.

By setting the position where the resistance heating elements are formed in this manner, heat generated from the resistance heating elements diffuses to the whole of the ceramic substrate while the heat is conducted. Thus, a temperature distribution in the face for heating an object to be heated (a semiconductor wafer) is made even so that the temperatures of respective portions of the object to be heated are made even.

The resistance heating elements may have a rectangular section or an elliptical section. They desirably have a flat section. From the flat section, heat is more easily radiated toward the heating face. Thus, a temperature distribution in the heating face cannot be easily generated.

The aspect ratio (the width of the resistance heating element/the thickness of the resistance heating element) of the section is desirably 10 to 5000.

Adjustment thereof into this range makes it possible to increase the resistance value of the resistance heating elements and keep the evenness of the temperature in the heating face.

In the case where the thickness of the resistance heating elements is made constant, the amount of heat conducted toward the heating face of the ceramic substrate becomes small when the aspect ratio is smaller than the above-mentioned range. Thus, a heat distribution similar to the pattern of the resistance heating elements is generated in the heating face. On the other hand, when the aspect ratio is too large, the temperature of the portions just above the centers of the resistance heating elements becomes high so that a heat distribution similar to the pattern of the resistance heating elements is generated in the heating face. Accordingly, when temperature distribution is considered, the aspect ratio of the section is preferably 10 to 5000.

When the resistance heating elements are formed inside the ceramic substrate, the aspect ratio is desirably 200 to 5000.

The aspect ratio becomes larger in the case where the resistance heating elements are formed inside the ceramic substrate. This is based on the following reason. When the resistance heating elements are formed inside, the distance between the heating face and the resistance heating elements becomes short so that temperature evenness in the surface deteriorates. It is therefore necessary to make the resistance heating elements themselves flat.

A conductor containing paste used when the resistance heating elements are formed is not particularly limited. However, preferably, the paste contains a resin, a solvent, a thickener or the like as well as metal particles or a conductive ceramic for ensuring electric conductivity.

The above-mentioned metal particles are preferably made of, for example, a noble metal (gold, silver, platinum or palladium), lead, tungsten, molybdenum, nickel or the like. Among them, the noble metal (gold, silver, platinum or palladium) is more preferred. These may be used alone, but are desirably used in combination of two or more. These metals are not relatively easily oxidized, and have a resistance value sufficient for generating heat.

Examples of the above-mentioned conductive ceramic include carbides of tungsten and molybdenum. These may be used alone or in combination of two or more.

The particle diameter of these metal particles or the conductive ceramic particles is preferably from 0.1 to 100 µm. When the particle diameter is too fine, that is, less than 0.1 µm, they are easily oxidized. On the other hand, when the particle diameter exceeds 100 µm, they are not easily sintered so that the resistance value becomes large.

The shape of the metal particles may be spherical or scaly. When these metal particles are used, they may be a mixture of spherical particles and scaly particles.

In the case where the metal particles are scaly or a mixture of spherical particles and scaly particles, metal oxides between the metal particles are easily held and adhesion between the resistance heating elements and the nitride ceramic or the like is made sure. Moreover, the resistance value can be made large. Thus, this case is profitable.

Examples of the resin used in the conductor containing paste include epoxy resin, phenol resin and the like. Examples of the solvent includes isopropyl alcohol and the like. Examples of the thickener include cellulose and the like.

It is desired to add a metal oxide to the metal particles in the conductor containing paste and make the resistance heating elements as a sintered body of the metal particles and the metal oxide, as described above. By sintering the metal oxide together with the metal particles in this way, the nitride ceramic or the carbide ceramic constituting the ceramic substrate can be closely adhered to the metal particles.

The reason why the adhesion to the nitride ceramic or the carbide ceramic by mixing the metal oxide is improved is unclear, but considered to be based on the following. The surface of the metal particles, or the surface of the nitride ceramic or the carbide ceramic is slightly oxidized so that an oxidized film is formed thereon. Pieces of this oxidized film are sintered and integrated with each other through the metal oxide so that the metal particles and the nitride ceramic or the carbide ceramic are closely adhered to each other.

A preferred example of the above-mentioned metal oxide is at least one selected from the group consisting of lead oxide, zinc oxide, silica, boron oxide (B₂O₃), alumina, yttria and titania.

These oxides make it possible to improve adhesion between the metal particles and the nitride ceramic or the carbide ceramic without increasingthe resistance value of the resistance heating elements.

When the total amount of the metal oxides is set to 100 parts by weight, the weight ratio of lead oxide, zinc oxide, silica, boron oxide (B₂O₃), alumina, yttria and titania is as follows: lead oxide: 1 to 10, silica: 1 to 30, boron oxide: 5 to 50, zinc oxide: 20 to 70, alumina: 1 to 10, yttria: 1 to 50 and titania: 1 to 50. The weight ratio is desirably adjusted within the scope that the total thereof does not exceed 100 parts by weight.

By adjusting the amounts of these oxides within these ranges, in particular, adhesion to the nitride ceramic can be improved.

The amount of the metal oxide added to the metal particles is preferably 0.1% or more by weight and less than 10% by weight.

For the resistance heating elements, a metal foil or a metal wire may be used. As the metal foil, a nickel foil or stainless steel foil made into heating elements by patterning based on etching or the like is preferred. The patterned metal foil may be stuck with a resin film or the like. Examples of the metal wire include a tungsten wire and a molybdenum wire and the like.

The area resistivity when the resistance heating elements are formed is preferably 0.1 mΩ/□ to 10 Ω/□. When the area resistivity is less than 0.1 Ω/□, the resistance heating element pattern must be made to be a very small width, such as a width of about 0.1 to 1 mm, in order to ensure the amount of generated heat. Consequently, a slight crack or the like in the pattern causes a break of the pattern or a variation in the resistance value. When the area resistivity exceeds 10 Ω/□, the amount of generated heat cannot be ensured unless the width of the resistance heating element pattern is made to be large. As a result, the flexibility of the design of the pattern deteriorates so that the temperature in the heating face is not easily made even.

In a ceramic heater according to another embodiment, a ceramic substrate which constitutes the ceramic heater is formed of a disc-shaped substrate body having a diameter larger than a wafer-heating region, and an external terminal is formed at the outside of the wafer-heating region.

Fig. 9 (a) is a sectional view which shows a ceramic heater having the above-mentioned structure, and Fig. 9(b) is a plan view thereof.

In this ceramic heater 90, a ceramic substrate 91 has a diameter larger than a wafer-heating region, and heating is performed by a resistance heating element 92, an external terminal 95, and a conductive body 93 for connecting the resistance heating element electrically to the external terminal.

In this ceramic heater 90, a seal ring 97 is formed outside the wafer-heating region of the ceramic substrate 91, and a chamber 94 is formed thereon. A protecting case is provided on the lower side. In Figs. 9, the wafer-heating region is represented by A.

In this ceramic heater 90, the power feeding terminal (external terminal) 95 is formed at the outside of the wafer-heating area A of the ceramic substrate 91, whereby a portion which is forced to contact corrosive gas can be limited into the wafer-heating region A and a semiconductor wafer can be evenly heated without exposing the external terminal 95 or the conductive body 93 for connecting the external terminal 95 to the resistance heating element 92 to the corrosive gas.

In the case where an electrostatic electrode layer is formed inside the ceramic substrate of the present invention, this ceramic substrate functions as an electrostatic chuck. In this case, the ceramic substrate which constitutes this electrostatic chuck is constructed in the almost similar manner to the above-mentioned ceramic heater except that the electrostatic electrode is formed.

The ceramic substrate of the present invention functions as a chuck top plate for a wafer prober by providing a chuck top conductive layer on a surface of the ceramic substrate and providing guard electrodes, ground electrodes and the like inside the ceramic substrate.

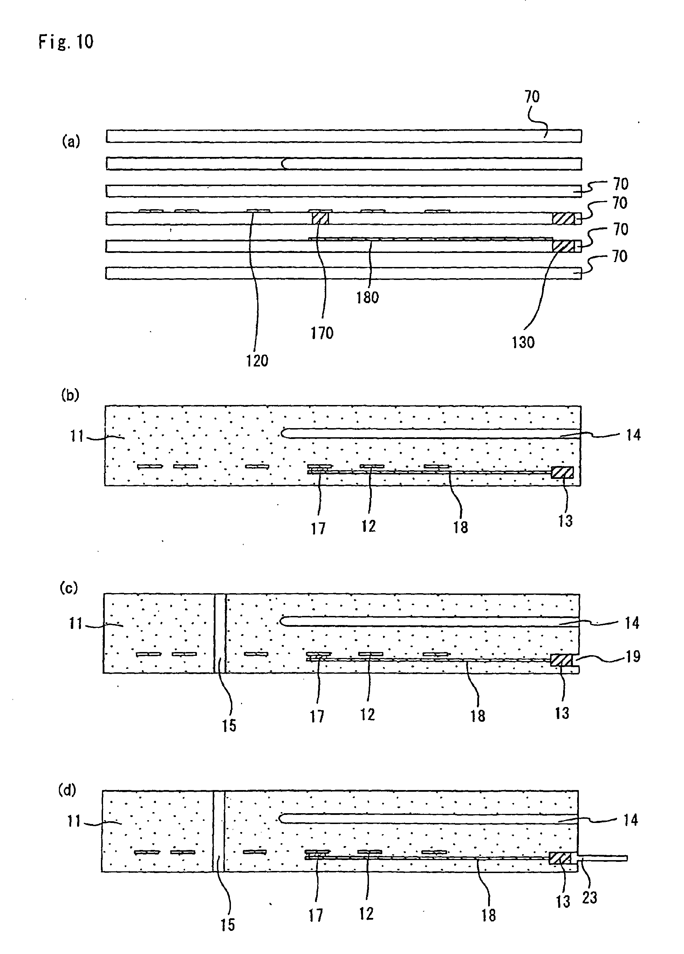

The following will describe a process for producing the ceramic heater 10 wherein the resistance heating elements 12a to 12c are formed on the ceramic substrate 11 (see Figs. 1 to 3) on the basis of Figs. 10.

### (1) Step of forming ceramic substrate

First, ceramic powder of a nitride or the like is mixed with a binder, a solvent and the like to prepare a paste. This is used to form green sheets 70 formed of a disc-shaped substrate and a substantially rectangular convex portion.

As the above-mentioned ceramic powder of the nitride or the like, aluminum nitride or the like can be used. If necessary, a sintering aid such as yttria, a compound containing Na or Ca, or the like may be added thereto.

As the binder, desirable is at least one selected from an acrylic resin binder, ethylcellulose, butylcellosolve, and polyvinyl alcohol.

As the solvent, desirable is at least one selected from α-terpineol and glycol.

A paste obtained by mixing these is formed into a sheet form by a doctor blade process, to produce green sheets.

The thickness of the green sheets is preferably 0.1 to 5 mm.

Next, there are formed :a green sheet wherein portions which will be via holes for connecting end portions of the resistance heating elements to conductive circuits are formed; a green sheet wherein portions which will be conductor-filled through holes for connecting the conductive circuits to external terminals are formed; and a green sheet wherein portions which will be bottomed holes are formed.

### (2) Step of printing conductor containing paste on green sheet

A metal paste or a conductor containing paste containing a conductive ceramic, for forming the resistance heating elements 12, is printed on the green sheet 70 wherein the portions which will be the via holes are formed, so as to form a conductor containing paste layer 120 for the resistance heating elements.

A conductor containing paste layer 180 for the conductor circuits is formed beneath the green sheet 70 wherein the portions which will be the via holes are formed.

A conductor containing paste filled layer 170 for the via holes is formed in the portions which will be the via holes, and a conductor containing paste filled layer 130 for the conductor-filled through holes is formed in the portions which will be the conductor-filled through holes.

These conductor containing pastes contain metal particles or conductive ceramic particles.

The above-mentioned pastes into which carbon is incorporated may be filled into the portions which will be the via holes and the portions which will be the conductor-filled through holes. This is because carbon in the green sheets reacts with tungsten or molybdenum filled in the conductor-filled through holes so that carbides thereof are formed.

The average particle diameter of tungsten particles or molybdenum particles, which are the above-mentioned metal particles, is preferably 0.1 to 5 µm. When the average particle is less than 0.1 µm or exceeds 5 µm, the conductor containing paste is not easily printed.

Such a conductor containing paste may be a composition (paste) obtained by mixing, for example, 85 to 87 parts by weight of the metal particles or the conductive ceramic particles; 1.5 to 10 to parts by weight of at least one binder selected from acrylic resin binders, ethylcellulose, butylcellosolve and polyvinyl alcohol; and 1.5 to 10 parts by weight of at least one solvent selected from α-terpineol and glycol.

### (3) Step of laminating green sheets

Green sheets 70 on which no conductor containing paste is printed are laminated on the upper and lower sides of the green sheet 70 wherein the portions which will be the bottomed holes are formed, and subsequently the following are laminated on the lower side thereof: a green sheet 70 on which the conductor containing paste is printed, and a green sheet 70 on which no conductor containing paste is printed (see Fig. 10(a)).

At this time, thelaminating is performed in such a manner that the green sheet 70 on which the conductor containing paste is printed is located at a position having a distance of 60% or less of the thickness of the laminated green sheets from the bottom face.

Specifically, the.number of the green sheets laminated on the upper side is preferably 20 to 50, and that of the green sheets laminated on the lower side is preferably 5 to 20.

### (4) Step of firing green sheet lamination

The green sheet lamination is heated and pressed to sinter the green sheets and the inner conductor containing paste.

The heating temperature is preferably 1000 to 2000°C, and the pressing pressure is preferably 10 to 20 MPa. The heating is performed in the atmosphere of an inert gas. As the inert gas, argon, nitrogen or the like can be used.

Next, in the resultant sinteredbody are formed the through holes 15 for lifter pins, through which lifter pins 16 for supporting a semiconductor wafer 29 will be passed; the conductor-filled through holes 13 for connecting the resistance heating elements 12 to external terminals 23; and the like (see Fig. 10(b)).

The above-mentioned steps of forming the through holes may be conducted to the above-mentioned green sheet lamination, but may preferably be applied to the above-mentioned sintered body. This is because the lamination may be deformed in the sintering step.

The through holes can be formed by grinding the surface and then subjecting the surface to blast treatment such as sandblast. Blind holes 19 are formed to expose the conductor-filled through holes 13 for the connection to the inner resistance heating elements 12 (see Fig. 10(c)). The external terminals 23 are inserted through solder or brazing material into the blind holes 19, and resultant is heated for re-flowing, thereby connecting the external terminals 23 to the conductor-filled through holes 13 (see Fig. 10(d)). The heating temperature is preferably 90 to 450°C in the case of solder treatment, and is preferably 900 to 1100°C inthe case of treatment with the brazing material.

Furthermore, thermocouples (not shown) as temperature measuring elements are attached to the bottomed holes 14 with brazing silver, brazing gold or the like, and then holes are sealed up with a heat-resistant resin such as polyimide, so as to finish the production of the ceramic heater 10.

### Best Modes for Carrying out the Invention

Hereinafter, the present invention will be described in more detail by way of examples.

### (Example 1)

### Production of ceramic heater (see Figs. 1 to 3 and 10)

(1) The following paste was used to perform formation by a doctor blade method, so as to form a sheet having a thickness of 0.47 mm: a paste obtained by mixing 100 parts by weight of aluminum nitride powder (manufactured by Tokuyama Corp. , average particle diameter: 0.6 µm), 4 parts by weight of alumina, 11.5 parts by weight of an acrylic resin binder, 0.5 part by weight of a dispersant and 53 parts by weight of alcohols of 1-butanol and ethanol.
(2) Next, this green sheet was dried at 80°C for 5 hours, and subsequently portions which would be conductor-filled through holes 13, via holes 17 and bottomed holes 14 were provided by punching and the like.
(3) The following were mixed to prepare a conductor containing paste A: 100 parts by weight of tungsten carbide particles having an average particle diameter of 1 µm, 3. 0 parts by weight of an acrylic resin binder, 3.5 parts by weight of α-terpineol solvent, and 0.3 part by weight of a dispersant.
   The following were mixed to prepare a conductor containing paste B: 100 parts by weight of tungsten particles having an average particle diameter of 3 µm, 1.9 parts by weight of an acrylic resin binder, 3.7 parts by weight of α-terpineol solvent, and 0.2 part by weight of a dispersant.
   This conductor containing paste A was printed on the green sheet by screen printing, so as to form a conductor containing paste layer 120 for resistance heating elements and a conductor containing paste layer 180 for conductor circuits. The printed patterns were made into a repetition pattern of winding lines in the outer circumference portion of the ceramic substrate 11 and a concentrically circular pattern in the inner circumference portion, as shown in Fig. 1.
   Further, the conductor containing paste B was filled into the portions which would be the conductor-filled through holes 13 to which external terminals 23 would be connected, and the portions which would be the via holes 17 for connecting the resistance heating elements 12 to the conductor circuits 18, so as to form a filled layer 130 for the conductor-filled through holes and a filled layer 170 for the via holes (see Fig. 10 (a)).
   37 green sheets on which no conductor containing paste was printed were stacked on the upper side (heating face side) of the green sheet that had been subj ected to the above-mentioned processing, and the same 13 green sheets were stacked on the lower side of the green sheet. The sheets were pressed and bonded to each other at 130°C and a pressure of 8 MPa to form a lamination (see Fig. 10(b)).
(4) Next, the resultant lamination was degreased at 600°C in the atmosphere of nitrogen gas for 5 hours and hot-pressed at 1890°C and a pressure of 15 MPa for 10 hours to yield a ceramic plate having a thickness of 3 mm and having therein the resistance heating elements 12 and the conductor circuits 18 each having a thickness of 6 µm and a width of 10 mm.
   Further, this ceramic plate was cut to be made into a shape formed of a disc shape and a convex portion. By the grinding treatment, the ceramic plate was made into a shape wherein a disc-shaped substrate body having a diameter of 340 mm was integrated with a substantially rectangular convex portion having a length in the longitudinal direction of 150 mm and a length in the lateral direction of 50 mm.
   The bottomed holes 14 were formed to be parallel to the main face of the ceramic substrate 11 and, further, had openings in a side face of the convex portion of the ceramic substrate 11. Tips of the bottomed holes 14 were arranged in the central portion and/or the outer circumference portion of the ceramic substrate 11.
(5) Next, the ceramic plate-formed body obtained in the (4) was ground with a diamond grindstone. Subsequently, a mask was placed thereon, and blast treatment with SiC particles and so on was conducted to make through holes 15 for lifter pins, through which lifter pins 16 for carrying a semiconductor wafer 29 would be passed.
(6) Next, the portions to f orm the conductor-filled through holes 13 were hollowed out to make blind holes 19 (see Fig. 10(c)). Brazing gold comprising Ni-Au was used and heated at 700°C for re-flowing to connect external terminals 23 made of kovar to the blind holes 19 (see Fig. 10(d)).
(7) Temperature measuring elements 180 for temperature-control were embedded in the bottomed holes 14 to yield a ceramic heater 10 of the present invention.

### (Example 2)

A ceramic heater 30 was produced in the similar manner to Example 1, as shown in Fig. 4, except that all the resistance heating elements 32 has a concentric shape and end portions thereof were extended to a side face of a convex portion of a ceramic substrate 31.

### (Example 3)

A ceramic heater was made to have a structure shown in Figs. 9, and the diameter of its ceramic substrate was set to 400 mm, which was a diameter two times larger than the diameter of its wafer-heating region. Conditions for producing the ceramic substrate were set to the similar conditions to Example 1, thus obtaining a ceramic heater 90.

### (Comparative Example 1)

A ceramic heater 50 having a structure having a cylindrical ceramic body 57, as shown in Fig. 11, was produced. The process for producing the ceramic substrate was basically similar to Example 1, but the shape of its ceramic substrate, patterns of its resistance heating elements, and others were different from those in Example 1.

Nitrogen gas was introduced, as an inert gas, into the cylindrical ceramic body 57.

The ceramic heaters according to Examples 1 to 3 and Comparative Example 1 were fixed into supporting cases, and subsequently silicon wafers were placed thereon, and evaluations were made by the following methods. The results are shown in Table 1.

### Evaluating methods

### (1) Observation of electrodes and conductive wires

The temperatures of the ceramic heaters were raised to 200°C in the atmosphere of chlorine gas, and subsequently states of corrosions of the electrode members and conductive wires formed at the ceramic heaters were observed.

In the ceramic heaters of Examples 1 and 2, only the portions except the convex portions were forced to contact the chlorine gas atmosphere.

### (2) Temperature evenness in heating face

The temperature of each of the ceramic heaters was raised to 200°C, and subsequently the highest temperature and the lowest temperature of the silicon wafer were measured with a thermoviewer (IR-16-2012-0012, manufactured by Nippon Datum Co.) and, then, temperature difference therebetween was calculated.

### (3) Observation of temperature in heating face of ceramic heater

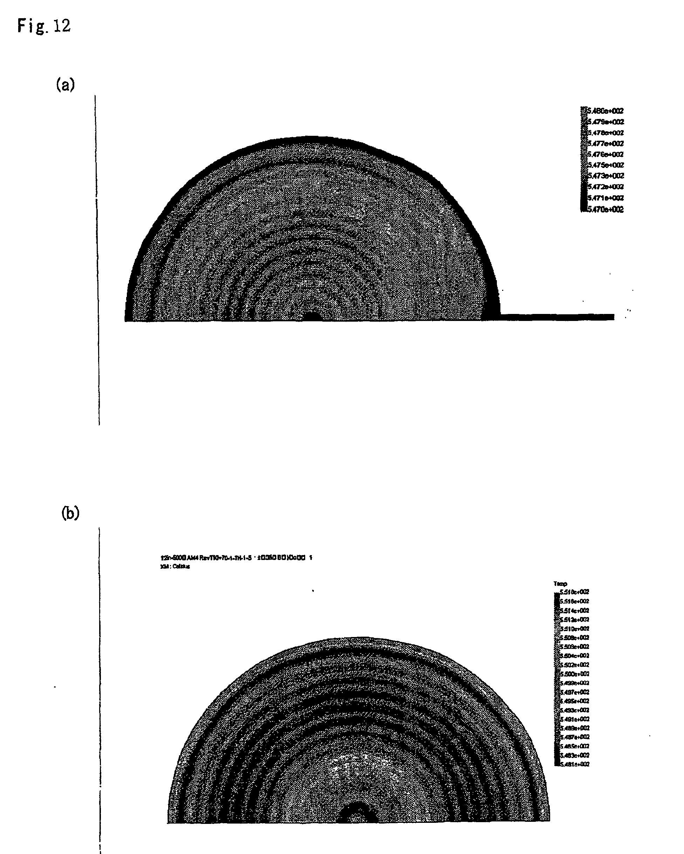

The setting temperatures of the ceramic heaters according to Example 1 and Comparative Example 1 were adjusted to be 550°C, and the temperatures thereof were raised. The heating faces were observed with a thermoviewer. The results are shown in Figs. 12. Fig. 12 (a) is a thermoviewer photograph obtained by observing the heating face of the ceramic heater according to Example 1, and Fig. 12 (b) is a thermoviewer photograph obtained by observing the heating face of the ceramic heater according to Comparative Example 1.

### (4) Measurement of applied electric powers and temperatures

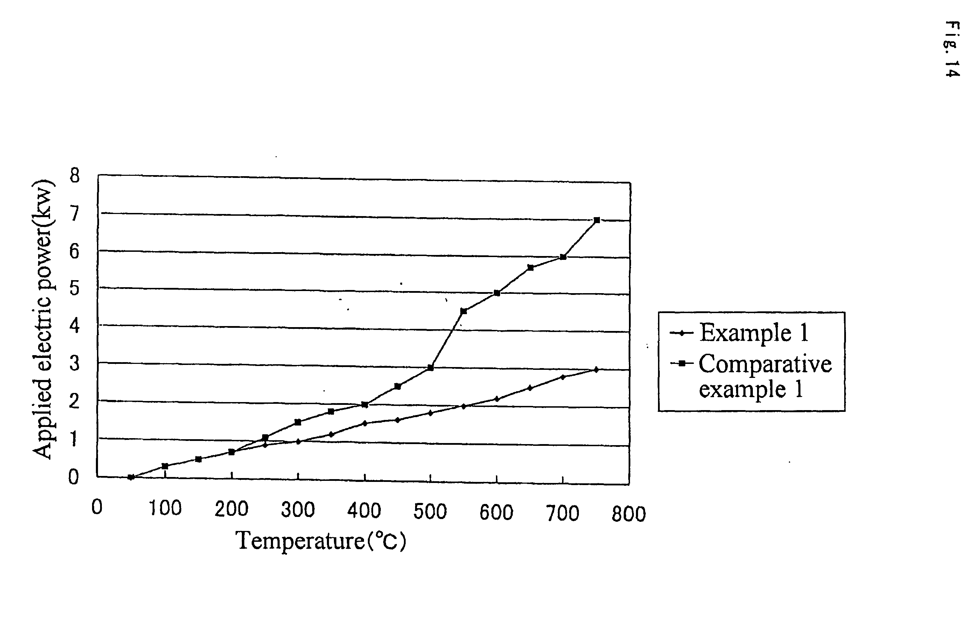

The temperatures of the ceramic heaters according to Example 1 and Comparative Example 1 were raised, and then applied electric powers and the temperatures were measured. Fig. 14 is a graph showing the relationship between the applied electric powers and the temperatures at that time.

**Table 1**

| | Corrosion of electrode members and conductive wires | Temperature evenness in heating face (°C) heating face (°C) |
|---|---|---|
| Example 1 | None | 1.0 |
| Example 2 | None | 0.8 |
| Example 3 | None | 0.5 |
| Comparative Example 1 | None | 4.0 |

As shown in Table 1, in the ceramic heaters according to Examples 1 to 3 and Comparative Example 1, no corrosion by chlorine gas was found out in the electrode members and the conductive wires.

This result is considered to be: because, in the ceramic heaters according to Examples 1 to 3, the electrode members and the conductive wires were able to be arranged outside the chorine gas atmosphere so as to avoid the exposion to the corrosive gas.

Also, this result is considered to be: because, in the ceramic heater according to Comparative Example 1, the electrode members and the conductive wires were protected by the material for blocking the corrosive gas.

On the other hand, in the ceramic heater according to Comparative Example 1, dispersion in the temperature in the heating face was found.

It can be considered to be because in the ceramic heater according to Comparative Example 1, the cylindrical ceramic body for protecting the electrode members, such as the external terminals, and the conductive wires from any corrosive gas was set in the vicinity of the central portion of the ceramic substrate, so that temperature unevenness was generated in the heating face, resulting from escape of heat toward the gas inside the cylindrical body, based on the introduction of inert gas into the cylindrical ceramic body, and escape of heat through the bonding portion for the ceramic substrate and the cylindrical ceramic body.

As shown in Figs. 12, about the ΔT temperature difference between the highest temperature and the lowest temperature in each ceramic heater, the ΔT was 6.5°C in the ceramic heater according to Comparative Example 1 since the temperature of the center thereof was low. Whereas, the ΔT was 0.7°C in the ceramic heater according to Example 1 since the temperature of the heating face was even.

As shown in Fig. 14, in the ceramic heater according to Example 1, the applied electric power was 3 kw even if the temperature was raised to 700°C. However, in the ceramic heater according to Comparative Example 1, an applied electric power up to 7 kw was necessary. The reason for this is unclear, but it appears that heat was conducted to flow out from the cylindrical ceramic body connected to the center portion and an excessive electric power was required for rise up to a predetermined temperature.

As described above, the ceramic heaters of the present invention are excellent in saving electric power.

### (Examples 4 to 8) Production of ceramic heaters wherein the thermal conductivities of ceramic substrates were varied

Instead of the step (1) in Example 1, the following paste was used to perform formation by a doctor blade method, so as to form a sheet having a thickness of 0.47 mm: a paste obtained by mixing 100 parts by weight of SiC powder (manufactured by Tokuyama Corp., average particle diameter: 0.5 µm), 5 parts by weight of B₄C, 11.5 parts by weight of an acrylic resin binder, 0.5 part by weight of a dispersant and 53 parts by weight of alcohols of 1-butanol and ethanol.

In the step (4) in Example 1, the lamination was degreased at 600°C for 5 hours, and fired under normal pressure to produce a porous body. At this time, the thermal conductivity was adjusted by performing sintering under firing conditions as shown in Table 2.

A ceramic heater was produced in the similar manner to Example 1 except the above-mentioned steps.

SiC has electrical conductivity, but if it is porous, the resistance heating elements have a smaller resistance value. Therefore, electric current flows in the resistance heating elements. For this reason, the resultant can be used as a ceramic heater inside which the resistance heating elements are embedded.

### (Comparative Examples 2 to 6) Production of ceramic heaters wherein the thermal conductivities of ceramic substrates were varied

The following paste was used to perform formation by a doctor blade method, so as to form a sheet having a thickness of 0.47 mm: a paste obtained by mixing 100 parts by weight of SiC powder (manufactured by Tokuyama Corp., average particle diameter: 0.5 µm), 5 parts by weight of B₄C, 11. 5 parts by weight of an acrylic resin binder, 0.5 part by weight of a dispersant and 53 parts by weight of alcohols of 1-butanol and ethanol. Further, the resultant was degreased at 600°C for 5 hours, and fired under normal pressure and under firing conditions as shown in Table 2 to produce a porous body. A ceramic heater was produced in the similar manner to Comparative Example 1 except the above-mentioned steps.

The thermal conductivities and porosities of the ceramic substrates constituting the ceramic heaters according to Examples 4 to 8 and Comparative Examples 2 to 6 are shown in Table 2.

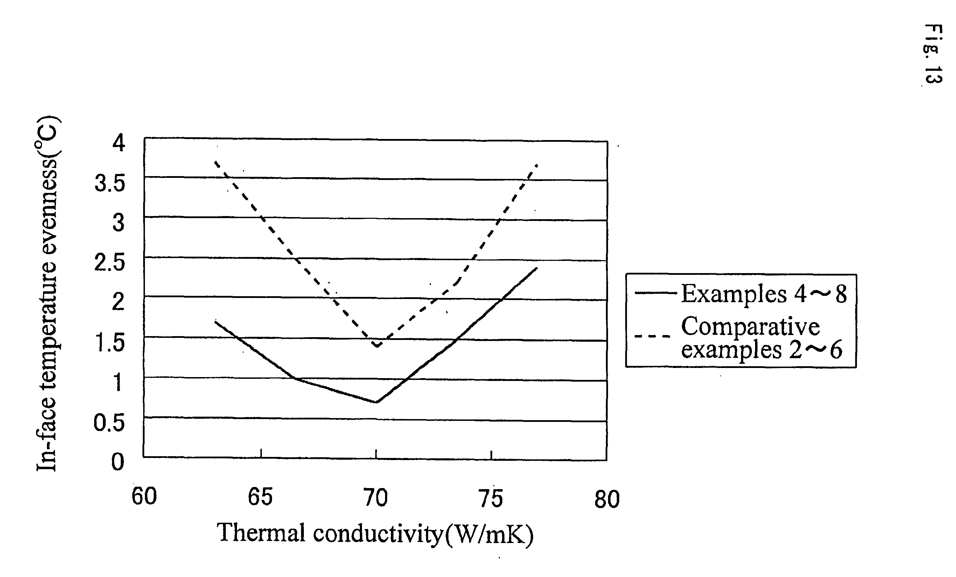

Fig. 13 shows the relationship between in-face temperatures and thermal conductivities of the ceramic heaters according to Examples 4 to 8 and Comparative Examples 2 to 6.

**Table 2**

| | Firing conditions | | Thermal conductivity (W/m·K) | Porosity (%) |
|---|---|---|---|---|
| | Temperature (°C) | Time (hour) | | |
| Example 4 | 1900 | 3 | 63 | 40 |
| Example 5 | 1900 | 5 | 68 | 38 |
| Example 6 | 2000 | 3 | 70 | 32 |
| Example 7 | 2000 | 5 | 75 | 30 |
| Example 8 | 2100 | 3 | 77 | 28 |
| Comparative Example 2 | 1900 | 3 | 63 | 40 |
| Comparative Example 3 | 1900 | 5 | 68 | 38 |
| Comparative Example 4 | 2000 | 3 | 70 | 32 |
| Comparative Example 5 | 2000 | 5 | 75 | 30 |
| Comparative Example 6 | 2100 | 3 | 77 | 28 |

As shown in Fig. 13, the structure of the present invention is advantageous in that, the dependency of the temperature of the ceramic heater upon the thermal conductivity of the ceramic substrate is far smaller and the in-face temperature evenness is excellent.

Heat is conducted into the cylindrical ceramic body in the ceramic heaters according to Comparative Examples 2 to 6; therefore, the temperature of the center of the ceramic heater at which the cylindrical ceramic body is bonded is lowered when the thermal conductivity of the ceramic substrate is raised, and conversely the cylindrical ceramic body functions as a heat insulating material so that the center temperature rises when the thermal conductivity of the ceramic substrate is lowered.

On the other hand, in the ceramic heater according to the present invention, no cylindrical ceramic body is present; therefore, such a problem is not caused, and the temperature of the ceramic heater does not depend upon the thermal conductivity of the ceramic substrate and the in-face temperature evenness is excellent.

### Industrial Applicability

As described above, according to the ceramic heater of the present invention, its ceramic substrate has a shape wherein a disc-shaped substrate and a convex portion are formed to be integrated with each other and the connection of its resistance heating elements to external terminals is made on a side face of this convex portion; therefore, in the case where the ceramic heater is fixed to a supporting case and is used in the process of producing a semiconductor while a semiconductor wafer is put on the ceramic heater, electrode members, such as the external terminals, and conductive wires can be formed outside of corrosive gas atmosphere. Consequently, the electrode members are not forced to contact the corrosive gas and deterioration in the performance of the ceramic heater can be prevented.

Even when the electrode members are present in the corrosive gas atmosphere in the process of producing a semiconductor, the electrode members concentrate in the vicinity of the convex portion of the ceramic substrate in the ceramic heater of the present invention. Therefore, by covering only this portion with a protective member which is made of a ceramic and is capable of blocking the corrosive gas, the ceramic heater can easily be protected from the corrosive gas and the corrosion of the electrode members can be prevented.

Furthermore, it is unnecessary for the ceramic heater of the present invention to provide a cylindrical ceramic body for protecting the electrode members, such as the external terminals and the like, and the conductive wires from the corrosive gas in the vicinity of the central portion of the ceramic substrate, unlike conventional ceramic heaters. It is therefore unnecessary to consider temperature unevenness in the heating face, resulting from escape of heat toward the gas inside the cylindrical body, based on the introduction of inert gas into the cylindrical ceramic body, and escape of heat through the bonding portion for the ceramic substrate and the cylindrical ceramic body. As a result, a semiconductor wafer, which is an object to be heated, can be evenly heated.

## Claims

1. A ceramic heater for a semiconductor producing/inspecting device comprising:
a ceramic substrate; and
a resistance heating element formed inside the ceramic substrate,
wherein
a power feeding terminal is formed to be exposed at the outside of a wafer-heating region of said ceramic substrate.

2. The ceramic heater for a semiconductor producing/inspecting device according to Claim 1,
wherein
said wafer-heating region is a portion extending from a face opposing a wafer, to a face opposite to the face opposing a wafer, of the ceramic substrate.

3. The ceramic heater for a semiconductor producing/inspecting device according to Claim 1 or 2,
wherein:
said ceramic substrate is constituted by a disc-shaped substrate, and a convex portion formed on its side face; and
the connection between the resistance heating element inside said ceramic substrate and an external terminal is made through a conductor inside the convex portion.

4. The ceramic heater for a semiconductor producing/inspecting device according to Claim 1 or 2,
wherein:
said ceramic substrate is: a disc-shaped substrate body having a diameter larger than the wafer-heating region; and
an external terminal is formed at the outside of the wafer-heating region.

5. The ceramic heater for a semiconductor producing/inspecting device according to any of Claims 1 to 4,
a bottomed hole is formed in a side face of said ceramic substrate; and
a temperature measuring element is inserted into the bottomed hole.
